## Europäisches Patentamt
## European Patent Office
## Office européen des brevets

(11) Numéro de publication: **0 354 842**
**A1**

## (12) DEMANDE DE BREVET EUROPEEN

(21) Numéro de dépôt: **89402238.3**

(22) Date de dépôt: **08.08.89**

(51) Int. Cl.⁵: **H 03 K 5/12**
**H 04 N 5/14**

(30) Priorité: **12.08.88 FR 8810878**

(43) Date de publication de la demande:
**14.02.90 Bulletin 90/07**

(84) Etats contractants désignés: **DE GB**

(71) Demandeur: **THOMSON VIDEO EQUIPEMENT**
**17, rue du Petit Albi**
**F-95800 Cergy Saint Christophe (FR)**

(72) Inventeur: **Artigalas, Max**
**THOMSON-CSF SCPI Cédex 67**
**F-92045 Paris la Défense (FR)**

**Grimaldi, Jean-Luc**
**THOMSON-CSF SCPI Cédex 67**
**F-92045 Paris la Défense (FR)**

(74) Mandataire: **Courtellemont, Alain et al**
**THOMSON-CSF SCPI**
**F-92045 PARIS LA DEFENSE CEDEX 67 (FR)**

(54) **Raidisseur de transition pour signal numérique et décodeur numérique analogique comportant un tel raidisseur à son entrée.**

(57) Le raidisseur est destiné à rendre plus raides les transitions d'un signal numérique vidéo, afin d'améliorer l'image à visualiser.

Par un simple filtrage passe-haut il est possible de raidir les transitions mais des phénomènes de rebond apparaissent en début et en fin de transition et peuvent être gênants ; c'est pourquoi les coefficients de pondération du circuit de filtrage (1) ne sont pas fixes mais sont commandés (4, 31-45) en fonction des caractéristiques du signal vidéo, ces caractéristiques étant constituées au minimum par la longueur (L) des transitions.

Application comme circuit d'entrée d'un décodeur numérique-analogique pour signal vidéo.

FIG_4

# Description

## RAIDISSEUR DE TRANSITION POUR SIGNAL NUMERIQUE ET DECODEUR NUMERIQUE-ANALOGIQUE COMPORTANT UN TEL RAIDISSEUR A SON ENTREE

La présente invention concerne un raidisseur de transition pour signal numérique ; c'est un circuit qui trouve sa principale application dans le raidissement des transitions d'un signal vidéo transmis sous forme numérique, en permettant d'améliorer artificiellement la qualité de l'image.

La bande passante des signaux vidéo à fronts raides est en général supérieure à la bande disponible lors d'une transmission ou d'un enregistrement. Cette réduction de bande amène un trainage des transitions et une gêne due au manque de définition lorsque l'image est visualisée. Comme il ne saurait être question d'utiliser des bandes passantes plus larges, il est nécessaire de trouver des moyens permettant de rendre artificiellement un piqué à l'image. Il est à noter qu'il s'agit là, en fait, d'un artifice destiné à tromper l'organe de vision et d'interprétation des images. Pour obtenir de bons résultats, les travaux des experts ont montré qu'il était nécessaire de maintenir, lors du traitement, le point de passage à demi-amplitude, et que, dans le cas des transitions de faible amplitude, le bruit prenait une importance considérable. Enfin le raidissement des transitions, quand il s'accompagne de dépassements, provoque un dédoublement ou un surlignage de la transition, préjudiciable à une bonne impression visuelle.

Il est connu de réaliser des raidisseurs à l'aide d'un filtre linéaire passe-haut, aux caractéristiques spécialement étudiées pour fournir, à partir du signal à corriger, un signal filtré qui, additionné au signal à corriger convenablement retardé, donne le signal corrigé. Une réalisation simple et performante est couramment employée sous le nom de "correcteur de contour" ; dans le domaine numérique le filtrage se fait avec des coefficients : un point filtré est par exemple obtenu en réalisant la somme pondérée entre la valeur du point correspondant, avant filtrage, affectée du coefficient 1 et les valeurs des deux points voisins affectées chacune du coefficient -0,5. Ce filtrage linéaire avec des coefficients dont certains sont obligatoirement négatifs, introduit des rebonds avant et après la transition et ces rebonds sont d'autant plus importants que la transition doit être plus raidie.

Le but de l'invention est d'améliorer la qualité du signal fournie par un raidisseur.

Ceci est obtenu en particulier à l'aide d'un raidisseur muni d'un circuit de filtrage dont les caractéristiques sont commandées en fonction des caractéristiques de la transition à raidir.

Selon l'invention, il est proposé un raidisseur de transition pour signal numérique, comportant une entrée de signal, un circuit de filtrage passe-haut et un additionneur de sortie à deux entrées, l'entrée de signal du raidisseur étant couplée aux deux entrées de l'additionneur par deux trajets distincts dont l'un comporte le circuit de filtrage, caractérisé en ce qu'il comporte un circuit de commande pour mesurer les caractéristiques du signal de l'entrée de signal et, en fonction des caractéristiques mesurées, commander les coefficients de filtrage du circuit de filtrage, les caractéristiques mesurées étant au minimum constituées par la longueur des transitions du signal numérique.

La présente invention sera mieux comprise et d'autres caractéristiques apparaîtront à l'aide de la description ci-après et des figures s'y rapportant qui représentent :

- les figures 1 et 2, des schémas simplifiés de raidisseurs suivant l'invention,
- la figure 3, un diagramme des temps relatif à des signaux du raidisseur selon la figure 2,
- la figure 4, un schéma plus détaillé du raidisseur selon la figure 2.

Sur les différentes figures les éléments correspondants sont désignés par les mêmes références.

Dans les différents schémas les dispositifs de synchronisation précise, relevant de la technologie courante, n'ont pas été représentés en vue de rendre les dessins plus clairs et de simplifier l'exposé.

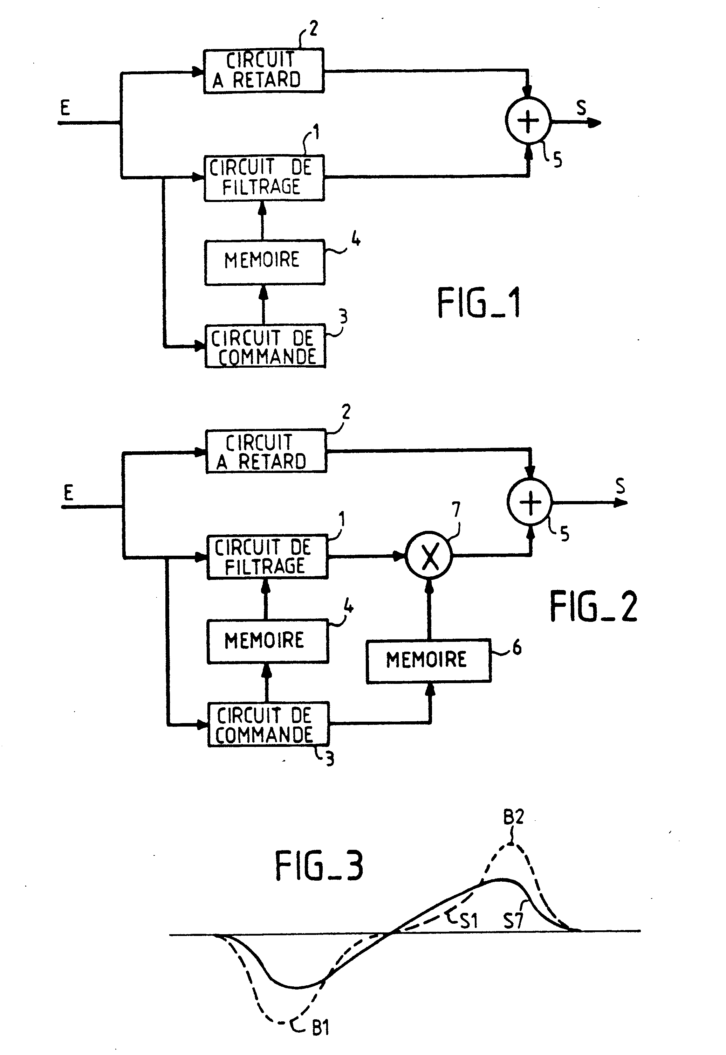

La figure 1 montre un raidisseur de transition dont l'entrée reçoit, sous forme de valeurs numériques par un câble multifilaire, un signal à corriger, E, échantillonné à une fréquence F = 1/Q ; le câble comporte un conducteur affecté au signe et un conducteur affecté à chacun des poids de la valeur absolue des signaux numériques à transmettre.

Grâce à un circuit additionneur 5, le signal E, retardé par un circuit à retard 2, est additionné à un signal de correction fourni par un circuit de filtrage 1 qui filtre le signal E ; le circuit à retard 2 introduit un retard égal au retard amené par le circuit de filtrage 1. L'additionneur 5 délivre un signal S qui est le signal E corrigé par le raidisseur. Il est courant de réaliser un raidisseur ne comportant que les éléments qui viennent d'être décrits et où les coefficients de pondération du circuit de filtrage 1 conservent des valeurs prédéterminées, quelles que soient les caractéristiques du signal E ; il en va différemment avec le montage selon la figure 1 puisqu'un circuit de commande 3, qui reçoit le signal E et en mesure les caractéristiques, commande, par une mémoire 4, les valeurs des coefficients de pondération du filtrage en fonction des caractéristiques mesurées. Le raidisseur selon la figure 1, en fonction du contenu de la mémoire 4, peut fonctionner avec un filtrage linéaire ou avec un filtrage non-linéaire, ce deuxième type de filtrage assurant une meilleure correction des transitions en permettant d'éviter ou, au moins, de réduire les rebonds, comme il apparaîtra à l'aide de la figure 3.

La figure 2 montre un raidisseur qui se distingue du raidisseur selon la figure 1 par l'adjonction d'une mémoire 6 et d'un multiplicateur 7. La lecture de la mémoire 6 est commandée par le circuit de commande 3, en fonction des caractéristiques du signal E, pour fournir un coefficient multiplicatif qui varie pendant la durée d'une transition pour tenir compte des caractéristiques du signal E. L'additionneur 5 ne reçoit plus le signal filtré délivré par le circuit de filtrage 1 mais le signal filtré et traité non-linéairement que lui délivre le multiplicateur 7. Ainsi avec le montage selon la figure 2 le filtrage et le traitement non linéaire du signal sont traités séparément, étant entendu que, si cela est désiré, la valeur du coefficient multiplicatif délivrée par la mémoire 6 peut être choisie constante et qu'alors le signal de correction délivré par le multiplicateur 7 à l'additionneur 5 sera le signal E après filtrage linéaire.

La figure 3 montre les valeurs représentatives du signal délivré par le circuit de filtrage 1 et par le multiplicateur 7 pour une même transition du signal E ; bien que ces valeurs constituent une succession de points à la fréquence $F = 1/Q$, elles ont été dessinées en traits interrompus pour le signal S1 filtré par le circuit 1 et en trait continu pour le signal S7 filtré et traité non-linéairement. La droite horizontale sur la figure 3 correspond à la valeur zéro. Comme il apparaît sur cette figure les rebonds, B1, B2, du signal filtré, S1, sont corrigés pour donner le signal S7 et cela grâce à un coefficient multiplicatif, qui varie autour de la valeur +1 au cours de la transition.

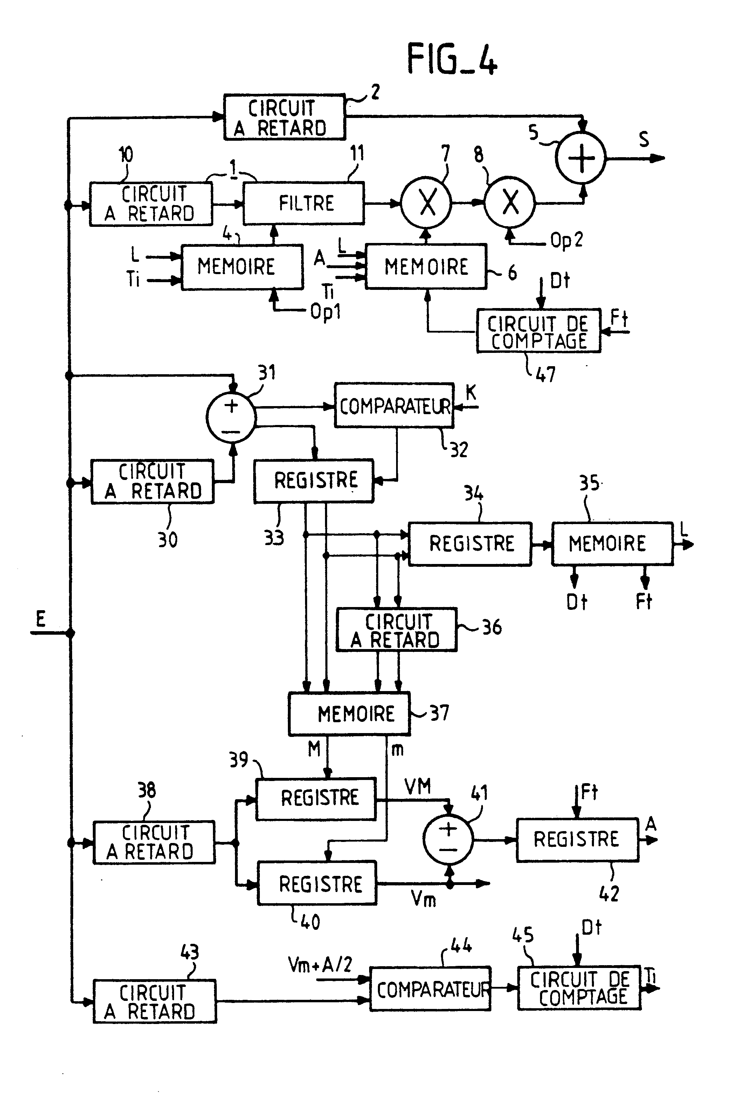

La figure 4 est un schéma plus détaillé du raidisseur selon la figure 2 avec, en plus, la possibilité d'intervention de l'utilisateur pour un réglage global du raidisseur en fonction des résultats désirés.

La figure 4 montre un signal numérique E, échantillonné à la fréquence $F = 1/Q$, qui est appliqué, à travers un circuit à retard 2, sur la première entrée d'un additionneur 5 et, à travers un circuit de filtrage 1 suivi de deux multiplicateurs en série 7 et 8, sur la seconde entrée de l'additionneur 5 ; le circuit de filtrage 1 est constitué par un circuit à retard 10 suivi d'un filtre passe-haut, 11. La sortie de l'additionneur 5 délivre le signal de sortie, S, du raidisseur.

Les coefficients de pondération du filtre 11 sont donnés par une mémoire 4 de type à lecture seule, programmable par l'utilisateur, connue sous le nom de PROM qui correspond aux initiales des mots anglais "Programmable Read-Only Memory".

En fonction des informations de longueur, L, et de position, Ti, de leur point à demi-amplitude, les transitions sont classées par familles, par exemple les transitions à 5 points d'échantillonnage, présentant donc une longueur L de 4 intervalles de longueur Q, avec un point milieu entre le troisième et le quatrième point d'échantillonnage. Ce classement est stocké dans la mémoire 4 qui reçoit, comme information de lecture, les informations de longueur, L, de position, Ti, de la demi-amplitude et aussi une information de choix, Op1, commandée par l'opérateur ; en effet pour une famille donnée, c'est-à-dire pour des valeurs L et Ti données, plusieurs sous-classes sont stockées dans la mémoire 4 qui donnent chacune un ensemble d'informations de commande du filtre 11 ; le choix des sous-classes est laissé à l'appréciation de l'opérateur, en fonction du résultat final, c'est-à-dire de la qualité d'image qu'il souhaite obtenir.

Une autre mémoire de type PROM, 6, avec un circuit à retard de sortie, est lue en fonction des valeurs de L, de Ti et de l'amplitude, A, de la transition ; dans la mémoire 6 sont stockées, pour chaque famille, les informations de traitement non-linéaire c'est-à-dire, pour chaque point d'une transition, le coefficient multiplicateur à appliquer, par la mémoire 6, au multiplicateur 7, comme il a été vu à l'aide de la figure 2 ; pour que les coefficients multiplicateurs arrivent sur le multiplicateur 7 en synchronisme avec les points correspondants du signal filtré fourni par le filtre 11, la lecture de la mémoire 6 se fait au rythme d'un circuit de comptage, 47, de période Q déclenché par un signal, Dt, correspondant au début de la transition et arrêté par un signal, Ft, correspondant à la fin de la transition. Le multiplicateur 8, qui reçoit sur une première entrée le signal filtré puis traité non-linéairement provenant du multiplicateur 7, reçoit sur une seconde entrée un signal Op2 qui est un coefficient multiplicateur constant laissé au choix de l'opérateur pour, là aussi, agir sur le résultat final.

La suite de la description de la figure 4 va montrer comment sont obtenus les signaux L, A, Ti, Dt, Ft correspondant respectivement aux informations de longueur, d'amplitude, de position de la demi-amplitude, de début et de fin de transition, qui ont été utilisées directement ou indirectement pour la lecture des mémoires 4 et 6.

L'information fondamentale, pour un raidisseur selon l'invention, est l'information L de longueur de transition et le montage selon la figure 4 pourrait être simplifié pour ne raidir les transitions du signal E qu'à l'aide de cette seule information, les transitions étant alors classées en fonction de leur seule longueur dans les mémoires 4 et 6 ; les autres informations ne sont pas, à strictement parler, nécessaires au fonctionnement du raidisseur mais elles permettent d'enrichir la connaissance du comportement du signal lors des transitions et donc de mieux adapter le traitement à la transition à traiter.

Pour déterminer les caractéristiques des transitions le signal numérique E est appliqué aux deux entrées d'un circuit différentiateur dont une entrée est constituée par la première entrée d'un soustracteur 31 et dont l'autre entrée est couplée à la seconde entrée du soustracteur 31 par un circuit à retard, 30, de durée Q. Ainsi est obtenue la différence entre le dernier échantillon reçu et l'échantillon précédent.

La valeur absolue de cette différence est appliquée sur la première entrée d'un comparateur 32 qui reçoit sur sa seconde entrée une valeur de seuil K. Le comparateur à seuil, 32, a un seuil K de faible amplitude, il permet ainsi d'éliminer les variations de faible amplitude entre deux échantillons successifs qu'elles soient dues à des variations lentes du signal E ou à des modulations éventuellement dues au bruit.

Le signe, "+" ou "-", de cette différence est appliqué sur une première entrée d'un registre 33. Si et seulement si cette différence est inférieure au seuil K, un signal signifiant "0" est appliqué sur une deuxième entrée du registre 33 par le comparateur 32.

Le registre 33 délivre les signaux "+", "-" ou "0" signifiant respectivement transition ascendante entre les deux derniers échantillons, transition descendante ou pas de transition. Le signal de sortie du registre 33 est appliqué à l'entrée d'un registre série-parallèle, à N positions, pour mémoriser les N derniers signaux "+", "-" ou "0" et permettre, grâce à une mémoire PROM, 35, branchée à la sortie du registre 34 de déterminer la longueur d'une transition : une transition montante est caractérisée par une suite de signes "+" et une transition décroissante par une suite de signes "-" ; la valeur N, qui est un nombre entier positif, est choisie telle que N.Q. soit au moins supérieur de 2.Q à la longueur de la plus grande transition que le raidisseur devra traiter.

La mémoire 35 fournit ainsi les signaux de longueur, L, de début, Dt, et de fin, Ft, de transition.

Les signaux de sortie du registre 33 sont également appliqués directement et indirectement par un circuit à retard 36 de durée Q, aux entrées de lecture d'une mémoire PROM, 37. La mémoire 37 est destinée à déterminer les instants d'apparition des minimums et des maximums du signal E qui sont repérés par des valeurs différentes sur les entrées de lecture, étant entendu que lorsque le registre 33 délivre une valeur signifiant "0" il délivre également un signe "+" ou un signe "-" mais qu' alors seul le "0" est à prendre en compte dans la mémoire 37, ce qui, d'ailleurs, est aussi le cas dans la mémoire 35 ; la mémoire 37 comporte deux sorties pour délivrer respectivement un signal m d'apparition d'un minimum et un signal M d'apparition d'un maximum ; le signal m ; est délivré quand les signaux provenant directement des circuits 33 et 36 sont respectivement soit "+", "-", soit "+", "0", soit "0", "-" ; et le signal M est délivré quand les signaux provenant directement des circuits 33 et 36 sont respectivement soit '"-", soit "+", soit "-", "0", soit "0", "+".

Le signal numérique E est appliqué, à travers un circuit à retard 38 de temps de retard 2Q, sur les entrées de deux registres 39, 40. La prise en compte des échantillons du signal E retardé, est autorisée dans le registre 39 par le signal M et dans le registre 40 par le signal m les registres 39 et 40 délivrent ainsi respectivement les valeurs VM et Vm correspondant au dernier échantillon relatif à un maximum et au dernier échantillon relatif à un minimum. Un soustracteur 41 qui reçoit VM et Vm, délivre la différence entre ces deux valeurs à un registre 42 qui prend en compte cette différence sous la commande du signal Ft, c'est-à-dire à chaque fin de transition ; ainsi le registre 42 délivre un signal A représentatif de l'amplitude de la dernière transition du signal E et ce jusqu'à la fin de la transition suivante.

Le signal E est également appliqué, à travers un circuit à retard 43 de temps de retard N.Q sur l'une des entrées d'un comparateur 44 qui reçoit, sur l'autre de ses entrées, un signal Vm + A/2 correspondant à la demi-amplitude de la transition ; le circuit diviseur permettant d'obtenir le signal A/2 et l'additionneur qui fournit le signal Vm + A/2 n'ont pas été représentés parce qu'inutiles à la compréhension du fonctionnement du raidisseur. Ainsi le comparateur 44 délivre un signal dont les changements d'état sont significatifs du passage par le point milieu des transitions du signal E retardé par le circuit 43. Ce signal sert de signal de blocage pour un circuit de comptage, 45, de fréquence F = 1/Q, qui est initialisé par le signal Dt de début de transition ; au moment où il est bloqué le circuit de comptage 45 délivre le signal Ti correspondant au temps, évalué en un nombre entier de périodes Q, entre le début d'une transition et le passage par sa demi-amplitude.

Il est à noter que, compte tenu des traitements non linéaires effectués, il est intéressant que le signal E ait subi une interpolation avant d'être raidi afin d'augmenter le nombre de ses échantillons et, ainsi, d'éviter les phénomènes de repliement de spectre.

Le raidisseur selon la présente invention est principalement destiné à la réception d'un signal vidéo transmis sous forme numérique et est alors utilisé comme circuit d'entrée d'un décodeur numérique-analogique.

## Revendications

1. Raidisseur de transition pour signal numérique (E), comportant une entrée de signal, un circuit de filtrage passe-haut (1) et un additionneur de sortie (5) à deux entrées, l'entrée de signal du raidisseur étant couplée aux deux entrées de l'additionneur par deux trajets distincts dont l'un comporte le circuit de filtrage (1), caractérisé en ce qu'il comporte un circuit de commande (3) pour mesurer les caractéristiques du signal de l'entrée de signal et, en fonction des caractéristiques mesurées, commander les coefficients de filtrage du circuit de filtrage (1), les caractéristiques mesurées étant au minimum constituées par la longueur (L) des transitions du signal numérique (E).

2. Raidisseur selon la revendication 1, caractérisé en ce que le circuit de commande (3) comporte des moyens de mesure de la longueur des transitions du signal numérique (30-35) avec un circuit de comparaison (30, 31) pour comparer l'amplitude des échantillons successifs du signal numérique, suivi d'un circuit de contrôle (34, 35) pour repérer le nombre de comparaisons successives toutes significatives d'une variation positive d'amplitude d'un échantillon au suivant et le nombre de celles significatives d'une variation négative et en déduire la longueur (L) d'une transition du signal numérique (E).

3. Raidisseur selon la revendication 2, caractérisé en ce que le circuit de contrôle (34, 35) est également destiné à donner, en fonction des comparaisons successives toutes significatives d'une même variation, un signal de début (Dt) et un signal de fin (Ft) de transition du signal numérique (E).

4. Raidisseur selon la revendication 3, caractérisé en ce que le circuit de commande (3) comporte des moyens de mesure de l'amplitude des transitions du signal numérique (30-42) incluant le circuit de comparaison (30, 31) et le circuit de contrôle (34, 35) ainsi qu'un circuit de détermination d'amplitude (36-42) par mesure des amplitudes extrêmes des transitions du signal numérique (E) et détermination, à chaque signal de fin de transition (Ft), de la différence des amplitudes extrêmes (VM-Vm).

5. Raidisseur selon la revendication 4, caractérisé en ce que le circuit de commande (3) comporte des moyens de mesure du passage à demi-amplitude des transitions du signal numérique (30-45) incluant les moyens de mesure de l'amplitude (30-42) ainsi qu'un circuit de détermination du passage à demi-amplitude (43-45) par comparaison entre le signal numérique retardé et l'amplitude à demi-amplitude obtenue par la combinaison algébrique (Vm + A/2) d'une des valeurs de l'amplitude extrême (Vm) d'une transition et de la valeur de la moitié (A/2) de l'amplitude de cette transition.

6. Raidisseur selon l'une quelconque des revendications précédentes, caractérisé en ce qu'il comporte, en série entre le circuit de filtrage (1) et l'additionneur (5), un multiplicateur (7) commandé par le circuit de commande (3).

7. Décodeur numérique-analogique pour signal vidéo, caractérisé en ce qu'il comporte, comme circuit d'entrée, un raidisseur selon l'une quelconque des revendications précédentes.

FIG_1

FIG_2

FIG_3

# FIG_4

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | GB-A-2 124 844 (PIONEER ELECTRONIC CORP.) <br> * figure 1; page 1, lignes 5-15 * | 1 | H 03 K 5/12 <br> H 04 N 5/14 |
| A | N.H.K. LABORATORIES NOTE <br> no. 311, janvier 1985, pages 1-15, Tokyo, Japan; K. OKADA: "A digital contour-corrector for a high-definition TV camera" * paragraphes 2,3; figures 3,6,8 * | 1,7 | |
| A | NACHRICHTENTECHNISCHE ZEITSCHRIFT N.T.Z. <br> vol. 39, no. 4, avril 1986, pages 226-236, Berlin, D; H. SCHOENFELDER et al.: "Verbesserung der Farbfernseh-Bildqualität durch digitale Videosignalverarbeitung" * paragraphe: "Verbesserung der Bildscharfe"; figures 10-12 * | 1 | |
| A | DE-B-2 041 798 (LICENTIA PATENT-VERWALTUNGS-GMBH) <br> * colonne 3, lignes 4-50; figure 2 * | 1 | **DOMAINES TECHNIQUES RECHERCHES (Int. Cl.5)** <br><br> H 03 K 5/12 <br> H 04 N 5/14 <br> H 04 N 5/208 |
| A | EP-A-0 257 129 (ANT NACHRICHTENTECHNIK GMBH) <br> * colonne 5, ligne 43 - colonne 6, ligne 4; figure 6 * | 1 | |

Le présent rapport a été établi pour toutes les revendications

| Lieu de la recherche | Date d'achèvement de la recherche | Examinateur |
|---|---|---|
| BERLIN | 20-10-1989 | ARENDT M |

EPO FORM 1503 03.82 (P0402)